# EUROPÄISCHE PATENTSCHRIFT

(11) **EP 2 908 614 B1**
(45) Veröffentlichungstag und Bekanntmachung des Hinweises auf die Patenterteilung: **21.12.2016**
(21) Anmeldenummer: 15154198.4
(22) Anmeldetag: 06.02.2015
(51) Int. Cl.: H05K 13/08

(54) **Optisches Vermessen eines Bauelementes mit an gegenüberliegenden Seiten vorhandenen strukturellen Merkmalen**
Optical measuring of a component with structural features on opposing sides
Mesure optique d'un composant présentant des caractéristiques structurales sur des côtés opposés

(30) Priorität: 14.02.2014 DE 102014101901
(43) Veröffentlichungstag der Anmeldung: 19.08.2015
(73) Patentinhaber: ASM Assembly Systems GmbH & Co. KG, 81379 München (DE)
(72) Erfinder: Heilmann, Norbert, 81673 München (DE)
(74) Vertreter: Dilg, Haeusler, Schindelmann Patentanwaltsgesellschaft mbH

(56) Entgegenhaltungen:
- EP-A2- 1 003 212
- JP-A- 2013 077 648
- US-A1- 2011 293 168

## Beschreibung

### Technisches Gebiet

Die vorliegende Erfindung betrifft das technische Gebiet der Bestückung von Bauelementeträgern mit elektronischen Bauelementen. Insbesondere betrifft die vorliegende Erfindung die optische Vermessung von elektronischen Bauelementen im Vorfeld einer Bestückung. Im Einzelnen betrifft die vorliegende Erfindung (i) ein Verfahren zum Montieren eines elektronischen Bauelementes auf einen Bauelementeträger mit einer vorherigen Vermessung des elektronischen Bauelementes, (ii) ein Verfahren zum Überprüfen der Funktionsfähigkeit eines optoelektronischen Bauelementes im Vorfeld einer Bestückung eines Bauelementeträgers mit dem optoelektronischen Bauelement und (iii) einen Bestückautomaten zum Montieren eines optisch vermessenen elektronischen Bauelementes.

### Hintergrund der Erfindung

Der Einsatz von Leuchtdioden (LEDs), die in Scheinwerfern oder Leuchten verbaut werden, welche eine Projektion des Lichtes über optische Elemente wie Linsen oder Reflektoren beinhalten, oder die in Sensoren verbaut werden und hochgenau auf einen Empfänger ausgerichtet sein müssen, erfordert eine Ausrichtung der LEDs nach optischen Gesichtspunkten. Während derzeit oberflächenmontierte Bauelemente, und dazu zählen auch die meisten LEDs, ausschließlich nach ihrer geometrischen Mitte ausgerichtet werden, um sie positionsgenau zu bestücken, gibt es heute immer mehr Anwendungen, bei denen die LEDs primär nach dem Mittelpunkt ihrer Licht emittierenden Leuchtfläche bzw. des eingebauten LED-Chips ausgerichtet werden müssen.

In der Praxis besteht jedoch typischerweise ein (ungewollter) Versatz zwischen der geometrischen Mitte eines LED Bauelementes, die in der Praxis anhand der räumlichen Lage der Anschlusskontakte wie Anschlussflächen oder Anschlussbeinchen bestimmt wird, und der Licht emittierenden Leuchtfläche. Ein solcher Versatz kann zwischen 0 und 100 µm (100 x 10⁻⁶m) betragen.

Um jedoch nicht die geometrische Mitte sondern den Mittelpunkt der Licht emittierenden Fläche einer Leuchtdiode (LED) genau auf einer optischen Achse einer optischen Anordnung oder eines optoelektronischen Licht empfangenden Bauelementes auszurichten, muss also bei einer Bestückung eines Bauelementeträgers mit einem LED Bauelement die Licht emittierende Leuchtfläche mit einem optischen System vermessen werden und das LED Bauelement dann so auf dem Bauelementeträger platziert und fixiert werden, dass der Mittelpunkt der Licht emittierenden Leuchtfläche der betreffenden LED und nicht die geometrische Mitte des LED Bauelementes genau auf der in einem Bestückungsprogramm eines Bestückungsautomaten angegeben Bestückungsposition zu liegen kommt.

Um den räumlichen Versatz zwischen der Licht emittierenden Leuchtfläche und der geometrische Mitte eines LED Bauelementes annähernd zu bestimmen, ist es bekannt, das LED Bauelement entweder bereits in einer Zuführeinheit, mittels welcher das LED Bauelement einem Bestückungsautomaten zugeführt wird, oder an einem bestimmten Ort innerhalb des Bestückungsautomaten zu vermessen. Dann wird das LED Bauelement mit einem Aufnahmewerkzeug, beispielsweise einer Saugpipette, so abgeholt, dass das Aufnahmewerkzeug auf den zuvor gemessenen Mittelpunkt der Licht emittierenden Leuchtfläche aufsetzt. Danach wird das LED Bauelement ohne eine weitere Lagekorrektur auf eine vorgegebene Sollposition auf einen Bauelementeträger aufgesetzt. Problematisch bei diesem Vorgehen ist, dass für das LED Bauelement keine Lagekorrektur mehr erfolgen kann, welche erforderlich wäre, falls das LED Bauelement beispielsweise bei einem temporären Ablegen etwas verdreht wird oder verrutscht, weil dann die zuvor vorgenommene Lagevermessung der Licht emittierenden Leuchtfläche mehr oder weniger nutzlos ist. Außerdem könnte es im Extremfall einen so starken Versatz zwischen der Leuchtfläche und den elektrischen Anschlusskontakten geben, dass bei einer Bestückung basierend auf einer idealen Ausrichtung nach dem Mittelpunkt der Leuchtfläche, eine Verlötung des LED Bauelementes nicht mehr mit der nötigen Qualität erfolgen kann. Konsequenterweise sollte in einem solchen Fall eine Bestückung mit dem betreffenden LED Bauelement verhindert werden. Dies ist aber aufgrund der fehlenden Information betreffend des Versatzes zwischen der Licht emittierenden Leuchtfläche und den elektrischen Anschlusskontakten nicht möglich. Somit ergibt sich eine relativ geringe Prozesssicherheit beim Bestücken von Bauelementeträgern mit LED Bauelementen.

EP 1 003 212 A2 offenbart ein Verfahren zum optischen Vermessen der Lichtemission eines LED Bauelements und ein nachfolgendes Montieren bzw. Bonden des LED Bauelements auf einem Schaltungsträger. Dabei werden sowohl die Position von Anschlüssen an der Oberseite des LED Bauelements als auch die Position der lichtemittierende Fläche des LED Bauelements von einer Kamera vermessen. Bei der Montage des LED Bauelementes wird ein aus diesen Messungen bestimmter Versatz zwischen den Anschlüssen und der lichtemittierenden Fläche berücksichtigt, so dass sich die lichtemittierende Fläche nach der Montage exakt an einer gewünschten Position befindet.

JP 2013 077648 A offenbart ein Verfahren zum Montieren einer Linse auf einem Substrat, wobei die Linse exakt auf der optischen Achse eines lichtemittierenden Chips von einem optoelektronischen LED Bauelement platziert wird.

US 2011/293168 A1 offenbart ein Verfahren zum Montieren eines transparenten Körpers, insbesondere einer Linse, auf einer optoelektronischen Baugruppe, welche mehrere auf einem Substrat mittels einer Oberflächenmontage montierten LED Bauelemente umfasst. Die zu montierenden transparenten Körper werden von einem Bestückkopf aufgegriffen und deren Position an dem Bestückkopf wird mittels einer Kamera entweder von oben oder von unten erfasst. Danach wird der Bestückkopf relativ zu dem jeweiligen LED Bauelement exakt so positioniert, dass der transparente Körper exakt an einer Zielposition auf dem Substrat platziert wird.

### Zusammenfassung der Erfindung

Der vorliegenden Erfindung liegt die Aufgabe zugrunde, die Bestückung von elektronischen Bauelementen in Hinblick auf eine verbesserte Positionierung der strukturellen Merkmale der Bauelemente auf einem bestückten Bauelementeträger zu verbessern.

Diese Aufgabe wird gelöst durch die Gegenstände der unabhängigen Patentansprüche. Vorteilhafte Ausführungsformen der vorliegenden Erfindung sind in den abhängigen Ansprüchen beschrieben.

Gemäß einem ersten Aspekt der Erfindung wird ein Verfahren zum Montieren eines elektronischen Bauelementes auf einen Bauelementeträger beschrieben. Das beschriebene Verfahren weist auf (a) ein optisches Erfassen eines ersten Bildes von einer ersten Seite des Bauelementes, an welcher ein erstes strukturelles Merkmal des Bauelementes erkennbar ist, mittels einer ersten Kamera, (b) ein optisches Erfassen eines zweiten Bildes von einer zweiten Seite des Bauelementes, an welcher ein zweites strukturelles Merkmal des Bauelementes erkennbar ist, mittels einer zweiten Kamera, wobei die erste Seite und die zweite Seite einander gegenüberliegend sind und wobei das zweite strukturelle Merkmal konfiguriert ist, an einer vorbestimmten Position auf dem Bauelementeträger angeschlossen zu werden, (c) Orientieren des elektronischen Bauelementes so dass eine Mitte des ersten strukturellen Merkmals mit einer gewünschten Position relativ zu dem Bauelementeträger ausgerichtet ist, wobei das zweite strukturelle Merkmal von der vorbestimmten Position entsprechend versetzt sein kann, (d) Messen eines räumlichen Versatzes zwischen dem zweiten strukturellen Merkmal und dem ersten strukturellen Merkmal basierend auf dem ersten Bild und dem zweiten Bild, um die korrekte räumliche Position von dem ersten strukturellen Merkmal zu bestimmen, und (e) Montieren des elektronischen Bauelementes auf den Bauelementeträger, so dass die Mitte des ersten strukturellen Merkmals an einer gewünschten und vorbestimmten Position auf dem Bauelementeträger zu liegen kommt, wobei die Mitte von dem ersten strukturellen Merkmal relativ zu dem Bauelementeträger ausgerichtet ist, wobei das zweite strukturelle Merkmal von der vorgestimmten Position versetzt ist. Erfindungsgemäß ist das elektronische Bauelement ein oberflächenmontiertes optoelektronisches Bauelement, das erste strukturelle Merkmal ist ein Licht emittierender Chip oder ein Licht empfangender Chip des optoelektronischen Bauelementes, und das zweite strukturelle Merkmal ist zumindest ein elektrischer Anschluss des optoelektronischen Bauelementes.

Dem beschriebenen Verfahren liegt folgende Erkenntnis zugrunde: Für eine automatische Bestückung eines Bauelementeträgers mit einem elektronischen Bauelement mittels eines Bestückungsautomaten wird im Vorfeld bzw. kurz vor der Bestückung eine Positionsvermessung des Bauelementes durchgeführt. Dabei wird das Bauelement von einer Bauelement-Haltevorrichtung, beispielsweise einer Saugpipette, gehalten. In bekannter Weise wird bzw. werden dabei ein möglicher Versatz und/oder eine Winkellage des Bauelementes in Bezug zu der Bauelement-Haltevorrichtung bestimmt. Diese Bestimmung erfolgt anhand einer optischen Erfassung der Position eines ersten Strukturmerkmals, beispielsweise der elektrischen Anschlüsse oder der Außenkontur des Bauelementes. Der bestimmte räumliche Versatz und/oder die bestimmte Winkellage wird bzw. werden dann bei der Bestückung des Bauelementes durch eine geeignete Anpassung der Position und/oder der Winkellage der Bauelement-Haltevorrichtung bei dem Aufsetzvorgang des Bauelementes auf einen Bauelementeträger kompensiert. Falls die beiden strukturellen Merkmale jedoch einen unbekannten räumlichen Versatz zueinander haben und es bei einer Baugruppe aufweisend den mit dem Bauelement bestückten Bauelementeträger jedoch (auch) auf die räumliche Lage des zweiten strukturellen Merkmals in Bezug zu dem Bauelementeträger ankommt, dann kann der erfindungsgemäß bestimmte räumliche Versatz zwischen den beiden strukturellen Merkmalen beim Aufsetzen des Bauelementes in geeigneter Weise berücksichtigt werden.

Bei einem Aufsetzen oder Platzieren des Bauelements auf den zu bestückenden Bauelementeträger können sowohl (i) der Versatz zwischen dem ersten strukturellen Merkmal und der Bauelement-Haltevorrichtung und/oder die Winkellage des Bauelements in Bezug zu der Bauelement-Haltevorrichtung als auch (ii) der räumliche Versatz zwischen den beiden strukturellen Merkmalen berücksichtigt werden. Ferner kann bei Bedarf auch ein geeigneter Kompromiss zwischen den beiden mit (i) und (ii) bezeichneten mehr oder weniger kompensationsbedürftigen Aspekten beim Aufsetzen des Bauelementes berücksichtigt werden.

Es wird darauf hingewiesen, dass vor dem Montieren bzw. Aufsetzen des elektronischen Bauelementes auf einen Bauelementeträger das Bauelement gegebenenfalls noch von einer zusätzlichen (dritten) Kamera optisch erfasst werden kann, um in bekannter Weise die Position und/oder die Orientierung des von einer Bauelement-Haltevorrichtung aufgenommenen Bauelementes zu bestimmen, für welches der räumliche Versatz zwischen den beiden strukturellen Merkmalen des Bauelementes bereits bekannt ist.

Das beschriebene erfindungsgemäße Verfahren kann insbesondere dann auf vorteilhafte Weise angewendet werden, wenn die beiden strukturellen Merkmale jeweils lediglich von einer Richtung optisch erfasst werden können, weil sie von der anderen Richtung durch den Körper des Bauelementes abgedeckt werden. In diesem Fall kann nämlich mittels einer optischen Erfassung beispielsweise des ersten strukturellen Merkmals keine Information darüber gewonnen werden, an welcher Stelle sich das zweite strukturelle Merkmal befindet. Dann stellt das beschriebene Verfahren nicht nur die derzeit beste sondern wohl auch die einzige Möglichkeit dar, den räumlichen Versatz zwischen den beiden an gegenüberliegenden Seiten eines Bauelementes ausgebildeten strukturellen Merkmalen zu bestimmen.

Das erfindungsgemäße Verfahren wird zum optischen Vermessen der Struktur eines optoelektronischen Bauelementes verwendet. Für diese Anwendung ergeben sich derzeit besonders viele Vorteile, weil hier im Vergleich zu bekannten Verfahren eine genaue Positionierung eines optoelektronischen Bauelementes hinsichtlich seiner optischen Charakteristik, d.h. hinsichtlich der Position des Licht emittierenden Chips des optoelektronischen Bauelementes, möglich wird. Bei bekannten Verfahren werden die optoelektronischen Bauelemente nämlich lediglich anhand der räumlichen Lage von deren elektrischen Anschlusskontakten räumlich positioniert. Eine genaue Positionierung eines optoelektronischen Bauelementes auf einem Bauelementeträger im optischen Sinne ist jedoch nur dann möglich, wenn ein möglicher räumlicher Versatz der Licht emittierenden Leuchtfläche, welche durch den Licht emittierenden Chip gegeben ist, in Bezug zu der Lage der elektrischen Anschlusskontakte des optoelektronischen Bauelementes genau bekannt ist. Genau dieser räumliche Versatz kann mit dem hier beschriebenen Verfahren auf einfache und effiziente Weise bestimmt und beim Aufsetzen bzw. Platzieren des optoelektronischen Bauelementes berücksichtigt werden.

Bei einer Kenntnis des räumlichen Versatzes zwischen dem Licht emittierenden Chip und den elektrischen Anschlusskontakten, welche durch den Leadframe gegeben sind, kann somit eine genaue optische Positionierung des optoelektronischen Bauelementes auf einem Bauelementeträger erfolgen. Dabei muss kurz vor der Bestückung in bekannter Weise lediglich die räumliche Lage der elektrischen Anschlusskontakte des optoelektronischen Bauelementes erfasst werden. Bei der Bestückung des Bauelementeträgers mit dem optoelektronischen Bauelement kann dann der bestimmte räumliche Versatz in geeigneter Weise berücksichtigt und durch eine geänderte Positionierung der das Bauelement haltenden Haltevorrichtung kompensiert werden.

Das optoelektronischen Bauelement kann beispielsweise eine Laserdiode oder eine Licht Emittierende Diode (LED) sein. Ferner kann das optoelektronischen Bauelement auch ein Licht empfangendes Bauelement wie beispielsweise eine Fotodiode sein.

Das erfindungsgemäße Verfahren kann insbesondere beim Bestücken von Bauelementeträgern mit LEDs in Bestückungsautomaten oder auch beim so genannten Die-Bonden von LEDs auf vorteilhafte Weise verwendet werden, da es mit bekannten optischen Vermessungsverfahren bei einem Transport von LED Bauelementen mittels Saugpipetten zu keinem Zeitpunkt möglich ist, gleichzeitig ein Bild des LED Bauelementes von oben (d.h. von der Seite mit der Licht emittierenden Leuchtfläche) und von unten (d.h. von der Seite mit den elektrischen Anschlusskontakten) aufzunehmen. Deshalb ist für eine genaue Bestückung im optischen Sinne die Verwendung des hier beschriebenen Verfahrens unbedingt erforderlich, um einen eindeutigen örtlichen Bezug zwischen (i) der räumlichen Lage der elektrischen Anschluss Kontakte, die sich an dem Leadframe oder direkt an dem Licht emittierenden Chip befinden, und (ii) der räumlichen Lage der Licht emittierenden Leuchtfläche zu bestimmen. Wie bereits vorstehend erläutert, ist eine Kenntnis dieses örtlichen Bezuges zwingend erforderlich, um das LED Bauelement auf dem bestückten Bauelementeträger optisch genau zu positionieren.

Gemäß einem Ausführungsbeispiel der Erfindung wird der räumliche Versatz in einer Ebene bestimmt, welche in Bezug zu der ersten Seite und/oder in Bezug zu der zweiten Seite parallel orientiert ist. Dies hat den Vorteil, dass der räumliche Versatz besonders genau gestimmt werden kann. Dies gilt insbesondere dann, wenn die beiden Bilder in einer Richtung aufgenommen werden, welche senkrecht zu der genannten Ebene ist.

Die Ebene kann bevorzugt mit einer Hauptebene des zu vermessenen elektronischen Bauelementes zusammenfallen. Die Hauptebene kann beispielsweise durch die Oberfläche eines in dem Bauelement enthaltenen Halbleitersubstrats gegeben sein. Ferner kann, alternativ oder in Kombination, die Hauptebene mit einer Oberfläche des Gehäuses des Bauelementes zusammenfallen oder parallel zu dieser orientiert sein.

Gemäß einem weiteren Ausführungsbeispiel der Erfindung weisen die erste Kamera und zweite Kamera einen festen räumlichen Bezug zueinander auf. Durch einen festen und möglichst genau bekannten räumlichen Bezug zwischen den beiden Kameras kann das beschriebene Verfahren mit einer hohen Genauigkeit durchgeführt werden. Dabei ist es nicht zwingend erforderlich, dass der feste räumliche Bezug zwischen beiden Kameras permanent gegeben ist. Vielmehr genügt es, wenn zu dem Zeitpunkt der jeweiligen Bildaufnahme der relative räumliche Bezug der beiden Kameras genau bekannt ist und dann bei dem Bestimmen des räumlichen Versatzes entsprechend berücksichtigt werden kann.

Gemäß einem weiteren Ausführungsbeispiel der Erfindung sind eine erste optische Achse der ersten Kamera und eine zweite optische Achse der zweiten Kamera kollinear zueinander ausgerichtet. In diesem Fall kann die relative räumliche Anordnung der beiden Kameras zueinander mit einer besonders hohen Genauigkeit realisiert werden. So kann für eine hochgenaue Ausrichtung der beiden Kameras beispielsweise ein Verfahren verwendet werden, bei dem sich die Kameras unmittelbar einander gegenüber stehen und jeweils ein Bild der anderen Kamera aufnehmen. Ein solches Verfahren zur Bestimmung der relativen räumlichen Lage zwischen zwei Kameras ist beispielsweise in DE 102 49 669 B3 beschrieben. Anhand der beiden aufgenommenen Kamerabilder kann dann die Position von zumindest einer der beiden Kameras so nachjustiert werden, dass die beiden Kameras hinsichtlich ihrer optischen Achse zumindest nahezu perfekt zueinander ausgerichtet sind.

Es wird darauf hingewiesen, dass für eine einfache und zugleich auch genaue räumlich Ausrichtung der beiden Kameras ein spezielles Glasbauteil verwendet werden kann, welches von beiden Kameras erfasst wird. Anhand von Markierungen, die sich auf dem Glasbauteil befinden, können dann die beiden Kameras mit hoher Genauigkeit ausgerichtet werden.

Eine zumindest nahezu perfekte Ausrichtung der beiden Kameras kann insbesondere den Vorteil haben, dass das in diesem Dokument beschriebene Verfahren mit einer hohen Genauigkeit ausgeführt werden kann und damit die Genauigkeit einer mittels Bestückung hergestellten elektronischen Baugruppe verbessert wird.

Gemäß einem weiteren Ausführungsbeispiel der Erfindung ist die erste Kamera und/oder die zweite Kamera eine innerhalb eines Bestückungsautomaten bewegliche Kamera.

Die bewegliche Kamera kann beispielsweise innerhalb des Bestückungsautomaten mittels eines Positionierung-bzw. Portalsystems verfahren werden. Bevorzugt kann die bewegliche Kamera an einem Bestückungskopf des Bestückungsautomaten angebracht werden und zusammen mit dem Bestückungskopf in oder an dem Bestückungsautomaten zu der Position verfahren werden, in der das entsprechende Bild des Bauelementes aufgenommen wird. Zwischen zwei aufeinander folgenden Bildaufnahmen von zwei unterschiedlichen elektronischen Bauelementen kann die Kamera dann an eine andere Positionen gebracht werden, in der sie beispielsweise (i) die Position und/oder die Lage eines Bauelement relativ zu der das Bauelement haltenden Haltevorrichtung erfasst und/oder (ii) die Position eines in einen Bestückungsbereich des Bestückungsautomaten eingebrachten und zu bestückenden Bauelementeträgers erfasst. Damit kann das beschriebene Verfahren mit ohnehin bereits vorhandenen Kameras eines Bestückungsautomaten durchgeführt werden. Es apparativer Umbau eines Bestückungsautomaten ist daher nicht oder nur in geringem Maße notwendig, um das beschriebene Verfahren auszuführen.

Gemäß einem weiteren Ausführungsbeispiel der Erfindung befindet sich das Bauelement während des Erfassens des ersten Bildes und während des Erfassens des zweiten Bildes in der gleichen Position. Dies hat den Vorteil, dass das Verfahren mit einer besonders hohen Genauigkeit ausgeführt werden kann. Eine Unsicherheit hinsichtlich einer Bewegung des Bauelementes zwischen zwei unterschiedlichen Positionen, in denen jeweils ein Bild aufgenommen wird, kann damit vermieden werden.

Gemäß einem weiteren Ausführungsbeispiel der Erfindung werden das erste Bild und das zweite Bild zu unterschiedlichen Zeitpunkten erfasst. Die beiden Bilder werden also nacheinander mit einem bestimmten zeitlichen Versatz erfasst. Diese Ausführungsform kann insbesondere dann von großem Vorteil sein, wenn zur Aufnahme von zumindest einem Bild eine kurze Erhellung, beispielsweise ein Blitz, erforderlich ist. Bei zeitlich auseinander fallenden Bildaufnahmen wird dann die Bildaufnahme durch eine Kamera auf vorteilhafte Weise nicht durch den Blitz für die andere Kamera gestört.

Gemäß einem weiteren Ausführungsbeispiel der Erfindung werden das erste Bild und das zweite Bild gleichzeitig erfasst. Dies hat den Vorteil, dass der Prozess des Erfassens der beiden Bilder besonders schnell ausgeführt werden kann. Damit kann auch das gesamte Verfahren zum optischen Vermessen der Struktur des elektronischen Bauelementes schneller durchgeführt werden. Bei einer Bestückung mit einem Bestückungsautomaten, für welche das beschriebene Verfahren ausgeführt wird, kann sich somit eine höhere Bestückungsleistung ergeben, wobei die Bestückungsleistung beispielsweise durch die Anzahl der Bauelemente bestimmt sein kann, welche innerhalb einer vorgegebene Zeit, beispielsweise eine Sekunde, auf einen oder auf mehrere Bauelementeträger aufgesetzt werden können.

Gemäß einem weiteren Ausführungsbeispiel der Erfindung befindet sich das Bauelement während des Erfassens des ersten Bildes in einer ersten Position und während des Erfassens des zweiten Bildes in einer zweiten Position. Die erste Position ist unterschiedlich zu der zweiten Position. Anschaulich ausgedrückt erfolgt gemäß dem hier beschriebenen Ausführungsbeispiel die Erfassung der beiden Bilder, welche jeweils ein an einer Seite des elektronischen Bauelementes befindliches strukturelles Merkmal zeigen, in unterschiedlichen Positionen des Bauelementes. Das elektronische Bauelement muss also zwischen der ersten Bildaufnahme und der zweiten Bildaufnahme bewegt werden. Dies erfolgt typischerweise mittels einer Bauelement-Haltevorrichtung, welche an einem Bestückungskopf angebracht ist.

Die Bildaufnahme in unterschiedlichen Positionen des Bauelementes hat insbesondere bei der Verwendung von Lichtquellen zum Beleuchten des aufzunehmenden Bauelementes den Vorteil, dass es nicht zu Störungen der optischen Bildaufnahme mittels einer Kamera durch eine der anderen Kamera zugeordneten Beleuchtung kommen kann.

Ein weiterer Vorteil der Bildaufnahmen in unterschiedlichen Positionen des elektronischen Bauelementes kann darin bestehen, dass in einem Bestückungssautomaten ohnehin bereits vorhandene Kameras, die auch für andere Mess-bzw. Inspektionsaufgaben verwendet werden, für das hier beschriebene Verfahren verwendet werden können. Damit erfordert die Durchführung des hier beschriebenen Verfahrens in einem oder mittels eines bekannten Bestückungssautomaten keinen oder nur einen lediglich sehr geringen apparativen Aufwand hinsichtlich eines gegebenenfalls erforderlichen Umbaus des Bestückungsautomaten.

Es wird darauf hingewiesen, dass die Durchführung des hier beschriebenen Verfahrens, bei dem die beiden Bilder des Bauelementes in unterschiedlichen Positionen des Bauelementes aufgenommen werden, eine genaue Kenntnis über die relative räumliche Lage der beiden Positionen erfordert. Dies bedeutet, dass die Strecke, entlang welcher das Bauelement zwischen den beiden Positionen bewegt wird, genau bekannt sein muss. Dies erfordert naturgemäß eine hohe Präzision von entsprechenden Positionierungssystemen, mittels welchen eine Haltevorrichtung für das Bauelement innerhalb eines Bestückungsautomaten bewegt wird.

Gemäß einem weiteren Ausführungsbeispiel der Erfindung befindet sich das elektronische Bauelement auf einem optisch transparenten Auflageelement, wenn zumindest eines der beiden Bilder optisch erfasst wird.

Das optisch transparente Auflageelement kann beispielsweise eine Glasplatte sein, wobei das Bauelement (i) von einer unterhalb der Glasplatte befindlichen Kamera mittels einer optischen Durchlicht-Konfiguration und (ii) von einer oberhalb der Glasplatte befindlichen Kamera mittels einer optischen Auflicht-Konfiguration erfasst wird.

Zur Durchführung des hier beschriebenen Verfahrens innerhalb eines bekannten Bestückungsautomaten ist abgesehen von der Bereitstellung von zwei geeigneten Kameras dann lediglich ein optisch transparentes Auflageelement erforderlich, auf welchem das jeweils zu erfassende elektronische Bauelement vorübergehend zum Zwecke von der Aufnahme von zumindest einem der beiden Bilder abgelegt wird.

Gemäß einem weiteren Ausführungsbeispiel der Erfindung wird das elektronische Bauelement von einer Klemmvorrichtung gehalten, wenn zumindest eines der beiden Bilder optisch erfasst wird.

Die Klemmvorrichtung kann insbesondere derart ausgebildet sein, dass das zu erfassende elektronische Bauelement so gehalten wird, dass die Bildaufnahme des ersten und/oder des zweiten Bildes beispielsweise durch eine Klemmbacke der Klemmvorrichtung nicht behindert wird. Insbesondere kann das elektronische Bauelement von der Klemmvorrichtung seitlich gehalten werden, so dass das Bauelement mittels einer ersten Kamera von oben und mittels einer zweiten Kamera von unten erfasst werden kann.

Die Verwendung einer derartigen Klemmvorrichtung hat im Vergleich zu der Verwendung eines optisch transparenten Auflageelementes den Vorteil, dass keine unerwünschten optischen Spiegelungen auftreten können und somit eine problemlose Bildaufnahme mit einer hohen Qualität der resultierenden Bilder des Bauelementes erreicht werden kann. Dadurch wird die Genauigkeit des beschriebenen Verfahrens erhöht.

In diesem Zusammenhang wird darauf hingewiesen, dass bei der optischen Erfassung des Bauelementes durch ein optisch transparentes Auflageelement hindurch es insbesondere bei einer Auflicht-Beleuchtung des Bauelementes ebenfalls durch das optisch transparente Auflageelement hindurch in der Praxis regelmäßig zu Spiegelungen und/oder Lichtstreuungen kommen kann, welche beispielsweise durch Verschmutzungen auf dem optisch transparenten Auflageelement verursacht werden. In diesem Zusammenhang ist es leicht verständlich, dass solche Spiegelungen und/oder Lichtstreuungen die Qualität der erfassten Bilder erheblich verschlechtern. In der Praxis werden solche Verschmutzungen regelmäßig durch einen Abrieb verursacht, der von Bauelementen und/oder dem Auflageelement infolge eines Handlings der Bauelemente stammt.

In diesem Zusammenhang wird ferner darauf hingewiesen, dass eine Auflicht-Beleuchtung in der Praxis sehr wichtig sein kann, da in vielen Fällen lediglich mit einer solchen Beleuchtung elektronische Anschlüsse zuverlässig optisch erfasst werden können, welche sich an der Unterseite des betreffenden Bauelementes befinden.

Gemäß einem weiteren Ausführungsbeispiel der Erfindung (a) wird mittels der ersten Kamera und/oder mittels der zweiten Kamera mit jeweils einer Bildaufnahme eine Mehrzahl von Bildern von einer Mehrzahl von Bauelementen aufgenommen und damit optisch erfasst, wobei jeweils ein Bild einem Bauelement zugeordnet ist und (b) für jedes Bauelement der Mehrzahl von Bauelementen wird jeweils ein räumlicher Versatz zwischen zwei an bzw. auf unterschiedlichen Seiten des Bauelementes befindlichen strukturellen Merkmalen basierend auf den entsprechenden aus unterschiedlichen Richtungen aufgenommenen Bildern des Bauelementes bestimmt. Ferner wird (c) jedes der Mehrzahl von Bauelementen so wird, dass jeweils eine Mitte des ersten strukturellen Merkmals mit einer gewünschten Position relativ zu dem Bauelementeträger ausgerichtet ist, wobei das jeweilige zweite strukturelle Merkmal von der jeweiligen vorbestimmten Position entsprechend versetzt sein kann, und es wird (d) die Mehrzahl von Bauelementen auf den Bauelementeträger montiert bzw. aufgesetzt, wobei die Mitte von dem jeweiligen ersten strukturellen Merkmal relativ zu dem Bauelementeträger ausgerichtet ist, wobei das jeweilige zweite strukturelle Merkmal von der jeweiligen vorgestimmten Position versetzt ist.

Anschaulich ausgedrückt bedeutet dies, dass im Vorfeld der Bestückung eines Bauelementeträgers mit einer Mehrzahl von Bauelementen diese Bauelemente nicht einzelnen sondern zusammen mit anderen Bauelementen vermessen werden. Auf diese Weise kann das beschriebene Verfahren für eine Mehrzahl von Bauelementen besonders zügig durchgeführt werden, so dass die Bestückungsleistung des jeweiligen Bestückungsautomaten entsprechend erhöht wird.

Es ist auch möglich, dass die Mehrzahl von Bauelementen lediglich von einer der beiden Kameras mittels einer einzigen Bildaufnahme (von einer Richtung) optisch erfasst wird und mittels der Kamera (von der anderen Richtung) einzeln optisch erfasst werden.

Gemäß einem weiteren Ausführungsbeispiel der Erfindung wird das erste Bild durch eine Saugpipette hindurch erfasst.

Dieses Ausführungsbeispiel kann insbesondere bei relativ großen elektronischen Bauelementen auf vorteilhafte Weise verwendet werden, da große elektronische Bauelemente typischerweise mit einer relativ großen Saugpipette gehalten werden. Eine große Saugpipette weist typischerweise einen breiten Saugkanal auf, in welche eine mit der ersten Kamera optisch gekoppelte Optik, beispielsweise ein Lichtwellenleiter, eingebaut werden kann. Das erste strukturelle Merkmal des Bauelementes wird dann über diese Optik erfasst. Damit kann beispielsweise die Licht emittierende Leuchtfläche bzw. der LED Chip eines LED Bauelementes optisch erfasst werden, während gleichzeitig die elektrischen Anschlüsse des LED Bauelementes vermessen werden. Ein Zwischenschritt über eine optische Messstation, bei der das Bauelement auf einer optisch transparenten Auflagefläche aufgelegt wird oder von einer Klemmvorrichtung gehalten wird, ist damit auf vorteilhafte Weise nicht erforderlich.

Gemäß einem weiteren Aspekt der Erfindung wird ein Verfahren zum Überprüfen der Funktionsfähigkeit eines optoelektronischen Bauelementes beschrieben. Das beschriebene Überprüfungsverfahren weist auf (a) ein Bestimmen eines räumlichen Versatzes zwischen (i) einem zweiten strukturellen Merkmal des optoelektronischen Bauelementes, welches sich an einer zweiten Seite des Bauelementes befindet, und (ii) einem ersten strukturellen Merkmal des optoelektronischen Bauelementes, welches sich an einer ersten Seite des Bauelementes befindet, wobei die erste Seite und die zweite Seite einander gegenüberliegend sind, mittels eines Teil-Verfahrens zum optischen Vermessen der Struktur von dem optoelektronischen Bauelement. Dieses Teil-Verfahren weist auf (a1) ein optisches Erfassen eines ersten Bildes von der ersten Seite des optoelektronischen Bauelementes mittels einer ersten Kamera, (a2) ein optisches Erfassen eines zweiten Bildes von der zweiten Seite des Bauelementes mittels einer zweiten Kamera und (a3) ein Bestimmen des räumlichen Versatzes basierend auf dem ersten Bild und dem zweiten Bild, wobei das optoelektronische Bauelement ein Licht emittierendes optoelektronisches Bauelement ist. Das Verfahren weist ferner auf, (b) ein Kontaktieren des Licht emittierenden optoelektronischen Bauelementes an einem optisch transparenten Trägerelement, (c) ein Einschalten des an dem optisch transparenten Trägerelement kontaktierten Licht emittierenden optoelektronischen Bauelementes, (d) ein Messen der Intensität von Licht, welches von dem eingeschalteten optoelektronischen Bauelement emittiert wird, und (e) ein Überprüfen der Funktionsfähigkeit des optoelektronischen Bauelementes basierend auf der gemessenen Intensität.

Dem beschriebenen Verfahren zum Überprüfen der Funktionsfähigkeit eines optoelektronischen Bauelements liegt die Erkenntnis zu Grunde, dass während des vorstehend beschriebenen Verfahrens zum Montieren eines elektronischen Bauelementes auf einen Bauelementeträger auch die Funktionsfähigkeit des optoelektronischen Bauelementes überprüft werden kann. Sollte sich dabei herausstellen, dass das betreffende optoelektronische Bauelement nicht funktioniert oder dass die emittierte Lichtintensität zu groß oder insbesondere zu klein ist, dann kann eine Produktion einer fehlerhaften elektronischen Baugruppe dadurch verhindert werden, dass das betreffende optoelektronische Bauelement für einen Bestückungsprozess, mit dem die elektronische Baugruppe hergestellt wird, nicht verwendet sondern verworfen wird. Auf diese Weise kann die Effizienz beim Herstellen von elektronischen Baugruppen mit optoelektronischen Bauelementen signifikant erhöht werden.

Gemäß einem Ausführungsbeispiel der Erfindung wird die räumliche Verteilung der lokalen Leuchtdichte über eine Leuchtfläche des optoelektronischen Bauelementes vermessen. Die Information über die Verteilung der lokalen Leuchtdichte und insbesondere über den genauen Ort auf der Leuchtfläche, wo die Leuchtdichte am größten ist, kann dazu verwendet werden, das Bauelement innerhalb einer optischen Vorrichtung noch genauer auszurichten.

Anschaulich formuliert kann man mit dem hier beschriebenen Verfahren bei einem Licht emittierenden optoelektronischen Bauelement den Ort auf der Licht emittierenden Fläche bzw. auf dem Licht emittierenden Chip messen, an welchem die Intensität des emittierten Lichtes maximal ist. Um also die beste optische Ausbeute bzw. die geringste optische Dämpfung bei einer optischen Kopplung zwischen dem Licht emittierenden optoelektronischen Bauelement und beispielsweise einem Lichtwellenleiter zu bekommen, kann man das Licht emittierende optoelektronische Bauelement durch ein "aktives Justieren", d.h. bei eingeschalteter Lichtquelle, solange verschieben, bis bei einem Empfänger die maximale Lichtmenge ankommt. Das bedeutet, dass man z.B. bei einer LED nicht automatisch die Mitte des Chips oder der Licht emittierenden Fläche für eine "optische" Justierung verwendet. Vielmehr kann man für die "optische" Justierung diejenige Stelle verwenden, an welcher der Chip oder die Licht emittierende Fläche die höchste lokale Leuchtdichte hat. Somit kann auf vorteilhafte Weise eine "optische" Ausrichtung eines Licht emittierenden optoelektronischen Bauelements verbessert werden. Dieser Aspekt der Erfindung ist für die meisten LEDs von Bedeutung, weil z.B. wegen Schwankungen im Herstellungsprozess des LED Chips die Lichtemission nicht gleichmäßig über die Fläche des Chips verteilt ist und damit die geometrische Mitte des Chips nicht der Ort mit maximaler Lichtintensität ist.

Gemäß einem weiteren Aspekt der Erfindung wird ein Bestückautomat zum Montieren eines elektronischen Bauelementes auf einen Bauelementeträger beschrieben. Der beschriebene Bestückautomat weist auf (a) einen Bestückkopf (i) zum Aufnehmen des elektronischen Bauelementes, (ii) zum Transportieren des aufgenommenen elektronischen Bauelementes über den Bauelementeträger und (iii) zum Aufsetzen des transportierten elektronischen Bauelementes auf den Bauelementeträger, (b) eine erste Kamera, (c) eine zweite Kamera und (d) eine mit den beiden Kameras gekoppelte Auswertevorrichtung, wobei die Auswertevorrichtung eingerichtet ist, den Bestückautomaten zu veranlassen, das vorstehend beschriebene Verfahren zum Montieren eines elektronischen Bauelementes auf einen Bauelementeträger auszuführen.

Es wird darauf hingewiesen, dass Ausführungsformen der Erfindung mit Bezug auf unterschiedliche Erfindungsgegenstände beschrieben wurden. Insbesondere sind einige Ausführungsformen der Erfindung mit Verfahrensansprüchen und andere Ausführungsformen der Erfindung mit einem Vorrichtungsanspruch beschrieben. Dem Fachmann wird jedoch bei der Lektüre dieser Anmeldung sofort klar werden, dass, sofern nicht explizit anders angegeben, zusätzlich zu einer Kombination von Merkmalen, die zu einem Typ von Erfindungsgegenstand gehören, auch eine beliebige Kombination von Merkmalen möglich ist, die zu unterschiedlichen Typen von Erfindungsgegenständen gehören.

Weitere Vorteile und Merkmale der vorliegenden Erfindung ergeben sich aus der folgenden beispielhaften Beschreibung derzeit bevorzugter Ausführungsformen. Die einzelnen Figuren der Zeichnung dieser Anmeldung sind lediglich als schematisch und als nicht maßstabsgetreu anzusehen.

### Kurze Beschreibung der Zeichnung

Figur 1a bis 1g zeigen einen Bestückungsvorgang, bei dem vor einem Aufsetzen eines Bauelementes auf einen Bauelementeträger die Struktur des Bauelementes mit einem optischen Messverfahren gemäß einem Ausführungsbeispiel der Erfindung vermessen wird.
Figur 2 zeigt eine Messstation, welche zusammen mit einer an einem Bestückungskopf angebrachten beweglichen Kamera das optische Messverfahren gemäß einem Ausführungsbeispiel der Erfindung durchführen kann.
Figur 3 zeigt ein LED Bauelement mit einem Versatz zwischen der geometrischen Mitte der elektrischen Anschlussstruktur und der geometrischen Mitte des Licht emittierenden LED Chips.

### Detaillierte Beschreibung

Es wird darauf hingewiesen, dass in der folgenden detaillierten Beschreibung Merkmale bzw. Komponenten von unterschiedlichen Ausführungsformen, die mit den entsprechenden Merkmalen bzw. Komponenten von einer anderen Ausführungsform nach gleich oder zumindest funktionsgleich sind, mit den gleichen Bezugszeichen oder mit einem Bezugszeichen versehen sind, welches sich von dem Bezugszeichen der gleichen oder zumindest funktionsgleichen Merkmale bzw. Komponenten lediglich in der ersten Ziffer unterscheidet. Zur Vermeidung von unnötigen Wiederholungen werden bereits anhand einer vorher beschriebenen Ausführungsform erläuterte Merkmale bzw. Komponenten an späterer Stelle nicht mehr im Detail erläutert.

Ferner wird darauf hingewiesen, dass die nachfolgend beschriebenen Ausführungsformen lediglich eine beschränkte Auswahl an möglichen Ausführungsvarianten der Erfindung darstellen. Insbesondere ist es möglich, die Merkmale einzelner Ausführungsformen in geeigneter Weise miteinander zu kombinieren, so dass für den Fachmann mit den hier explizit dargestellten Ausführungsvarianten eine Vielzahl von verschiedenen Ausführungsformen als offensichtlich offenbart anzusehen sind.

Wie bereits vorstehend beschrieben, kann mit dem in diesem Dokument beschriebenen Verfahren ein herstellungsbedingter räumlicher Versatz innerhalb eines LED Bauelementes zwischen (i) dem LED-Chip bzw. der Licht emittierenden Fläche des LED Bauelementes (erstes strukturelles Merkmal) und (ii) der Mitte der elektrischen Anschlüsse des LED Bauelementes (zweites strukturelles Merkmal) genau ermittelt werden. Dabei wird das LED Bauelement mit zwei genau zueinander justierten Kameras gleichzeitig oder kurz hintereinander von oben und von unten optisch erfasst. Bevorzugt wird das LED Bauelement zwischen den beiden Kameraaufnahmen nicht bewegt. Das Verfahren kann mit Bauelementen beliebiger Größe durchgeführt werden, solange die zu messenden Merkmale, d.h. die elektrischen Anschüsse bzw. Lötanschlüsse und der LED-Chip, innerhalb des Gesichtsfeldes der jeweiligen Kamera liegen.

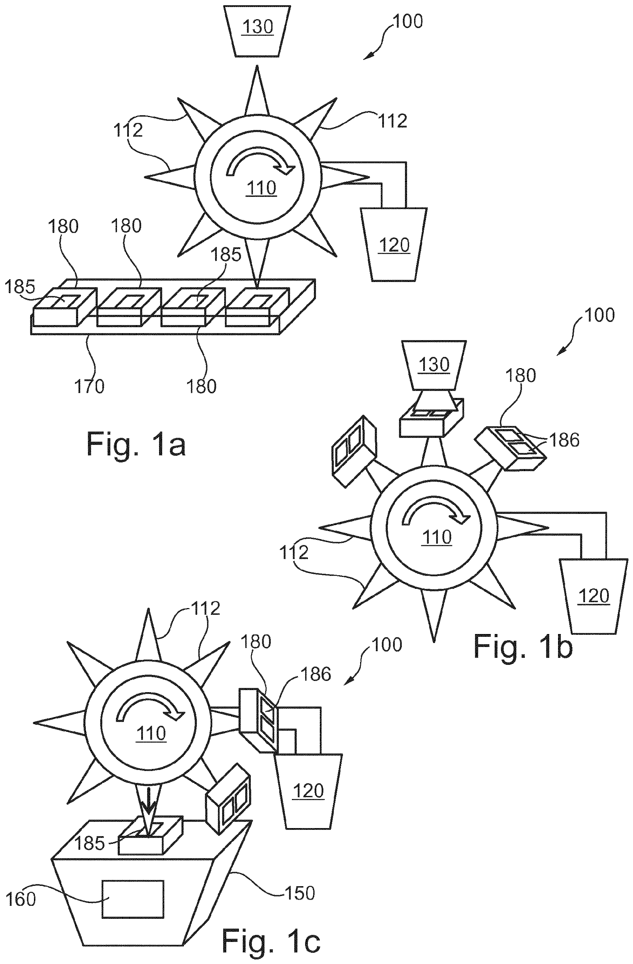

Die einzelnen Schritte zur Durchführung eines Ausführungsbeispiels des in diesem Dokument beschriebenen Verfahrens werden nachfolgend anhand der Figuren 1a bis 1g beschrieben. Gemäß dem hier beschriebenen Ausführungsbeispiel wird das Verfahren in einen Bestückungssystem 100 durchgeführt.

Wie aus **Figur 1a** ersichtlich, wird ein elektronisches LED Bauelement 180 mittels einer nicht dargestellten Zuführeinheit an eine Abholposition transferiert, von welcher es in bekannter Weise von einem Bestückungskopf 110 abgeholt werden kann. Die Bauelement-Zuführung erfolgt gemäß dem hier beschriebenen Ausführungsbeispiel mit einem Zuführgurt 170, in dem Aufnahmetaschen (nicht mit einem Bezugszeichen versehen) ausgebildet sind, in denen sich jeweils ein Bauelement 180 befindet.

Das LED Bauelement 180 weist einen LED Chip 185 auf, welcher in Figur 1a lediglich von oben erkennbar ist. In diesem Dokument wird der LED Chip 185 auch als Licht emittierende Fläche oder als erstes strukturelles Merkmal bezeichnet.

Gemäß dem hier dargestellten Ausführungsbeispiel ist der Bestückungskopf 110 ein so genannter Revolverkopf, welcher sich um eine senkrecht zu der Zeichenebene orientierte Drehachse drehen kann. Die Drehrichtung im Uhrzeigersinn ist in Figur 1a durch einen gebogenen Pfeil angedeutet. Selbstverständlich ist die dargestellte Drehrichtung nur beispielhaft und der Bestückungskopf 110 kann sich auch entgegen der Uhrzeigerrichtung drehen. Der Bestückungskopf 110 weist eine Mehrzahl von radial abstehenden Bauelement-Haltevorrichtungen auf, die gemäß dem hier dargestellten Ausführungsbeispiel als so genannte Saugpipetten 112 ausgebildet sind. Durch das Anlegen eines Unterdrucks an die Saugpipetten 112 kann an jeder Saugpipette 112 jeweils ein Bauelement 180 gehalten werden.

An dem Bestückungskopf 110 ist eine erste Kamera 120 angebracht. Da diese Kamera 120 üblicherweise zum Vermessen von Markierungen verwendet wird, welche auf einem zu bestückenden Bauelementeträger oder einer zu bestückenden Leiterplatte (nicht dargestellt) angebracht sind, wird diese Kamera häufig auch als Leiterplattenkamera 120 bezeichnet. Durch die Erfassung derartiger Markierungen wird in bekannter Weise die genaue Position einer in einen Bestückungsbereich des Bestückungssystems eingebrachten und zu bestückenden Leiterplatte bestimmt.

Gemäß dem hier dargestellten Ausführungsbeispiel ist an dem Bestückungskopf 110 ferner eine optionale weitere Kamera 130 angebracht, mittels welcher die von den Haltevorrichtungen 112 aufgenommenen Bauelemente 180 erfasst werden. Die weitere Kamera 130 wird deshalb häufig auch als Bauelementkamera bezeichnet. Basierend auf einer Bauelement-Erfassung können die Winkellage des aufgenommenen Bauelementes 180 sowie ein gegebenenfalls vorhandener Versatz zwischen der Mitte des Bauelementes 180 und der Längsachse der jeweiligen Saugpipette 112 ermittelt werden. Bei einem nachfolgenden Aufsetzen des Bauelementes 180 auf die Leiterplatte werden dann in bekannter Weise diese Winkellage sowie dieser Versatz durch eine geeignete Drehung der Saugpipette 112 um ihre Längsachse bzw. durch eine adaptierte Position des Bestückungskopfes 110 kompensiert.

Die optische Vermessung eines Bauelementes 180, welches sich im Gesichtsfeld der Bauelement Kamera 130 befindet, ist in **Figur 1b** dargestellt. In dieser Figur sind auch die Bauelement-Anschlüsse an der Unterseite des jeweiligen Bauelements 180 zu erkennen. Die Bauelement-Anschlüsse, welche in diesem Dokument auch als zweites strukturelles Merkmal bezeichnet werden, sind mit dem Bezugszeichen 186 versehen.

Wie vorstehend beschrieben, ist die Bauelementkamera 130 für die Durchführung des hier beschriebenen Verfahrens optional. Die Bauelement Kamera 130 kann jedoch von Bedeutung sein, um die Position des zu vermessenden Bauelementes 180 an der Saugpipette 112 zu bestimmen. Dadurch kann ein Ablegen des Bauelementes 180 an einer falschen Stelle vermieden werden, so dass das Bauelement mittels einer Kamera 160 einer Messstation 150 zuverlässig von unten erfasst werden kann. Das Ablegen des Bauelementes 180 auf der Oberseite der Messstation 150 ist in **Figur 1c** dargestellt. Das Ablegen des Bauelementes 180 erfolgt durch eine Bewegung der entsprechenden Saugpipette 112 nach unten. Diese Bewegung ist in Figur 1c mit einem geraden Pfeil illustriert.

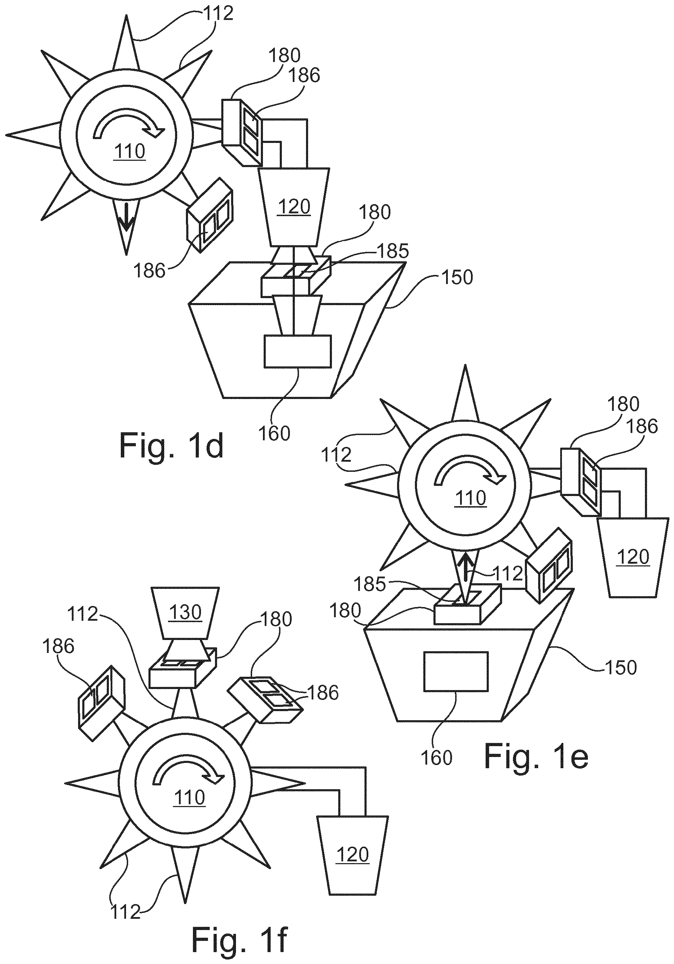

**Figur 1d** illustriert die gleichzeitige Vermessung des LED Bauelementes 180 (i) mittels der Kamera 160, welche in diesem Dokument auch als zweite Kamera 160 bezeichnet wird, und (ii) mittels der Leiterplattenkamera 120, welche in diesem Dokument auch als erste Kamera 120 bezeichnet wird. Dazu wurde der Bestückungskopf 110 so verfahren, dass sich die an ihm angebrachte Leiterplattenkamera 120 genau über dem auf der Messstation 150 abgelegten Bauelement 180 befindet. Basierend auf den zwei Bildern, die von den beiden Kameras 120 und 160 aufgenommen wurden, wird dann ein räumlicher Versatz zwischen (i) dem ersten strukturellen Merkmal bzw. dem LED Chip 185 an der Oberseite des LED Bauelementes 180 und (ii) den an der Unterseite des LED Bauelementes 180 ausgebildeten elektrischen Bauelement-Anschlüssen 186 bestimmt.

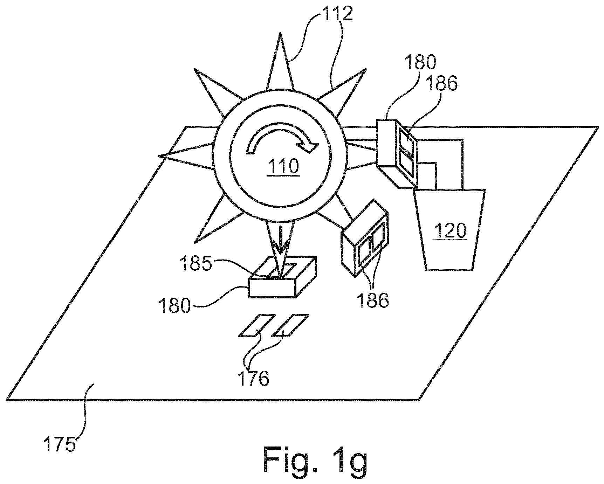

Nach der gleichzeitigen Erfassung sowohl der Oberseite als auch der Unterseite des Bauelementes 180 mit der Kamera 120 und der Kamera 160 wird das Bauelement 180 dann von der Messstation 150 abgeholt. Dies ist in **Figur 1e** dargestellt, in der die Saugpipette 112, mit der das Bauelement 180 abgeholt wird, mit einem nach oben gerichteten geraden Pfeil versehen ist. An dieser Stelle wird darauf hingewiesen, dass aus Gründen der Übersichtlichkeit nicht alle Bauelemente, welche von der Mehrzahl der Saugpipetten 112 aufgenommen werden können, in den Figuren 1a bis 1g dargestellt sind. Selbstverständlich können mit dem hier beschriebenen Verfahren jedoch mehrere Bauelemente quasi kontinuierlich vermessen werden. Dazu können selbstverständlich alle Saugpipetten 112 (in Figur 1 beispielhaft acht an der Zahl) verwendet werden.

Danach wird das abgeholte Bauelement 180 durch eine Drehung des Bestückungskopfes 110 entlang der mit einem gebogenen Pfeil dargestellten Drehrichtung in eine Position gebracht, in der es erneut von der Bauelementkamera 130 erfasst werden kann. Dies ist in **Figur 1f** dargestellt. Mit der Bauelementkamera 130 wird dann, wie zuvor bereits beschrieben, die Winkelposition des Bauelementes 180 sowie ein gegebenenfalls vorhandener Versatz zwischen dem Bauelement 180 und der Längsachse der entsprechenden Saugpipette 112 vermessen. Ein derartiges erneutes Vermessen des Bauelementes 180 mit der Kamera 130 kann insbesondere dann erforderlich sein, wenn das Bauelement 180 bei dem Ablegen auf und/oder bei dem Aufnehmen von der Messstation 150 versehentlich verrutscht oder verdreht wird.

**Figur 1g** zeigt das Aufsetzen des entsprechenden Bauelementes 180 auf einen Bauelementeträger bzw. auf eine Leiterplatte 175. Die Leiterplatte 175 weist Anschlusspads 176 auf, von denen in Figur 1g zwei dargestellt sind. Beim Aufsetzen des Bauelementes 180, welches Aufsetzen in Figur 1g durch einen nach unten gerichteten geraden Pfeil angedeutet ist, wird in bekannter Weise die zuvor ermittelte Winkellage und/oder ein ermittelter Versatz des LED Bauelementes 180 in Bezug zu der Längsachse der betreffenden Saugpipette 112 durch eine Drehung der Saugpipette 112 um ihre Längsachse bzw. durch eine adaptierte Position des Bestückungskopfes 110 kompensiert.

Zusätzlich zu dem vorstehend beschriebenen Kompensieren von der Winkellage und/oder von dem Versatz des Bauelementes 180 relativ zu der Saugpipette 112 wird gemäß dem hier beschriebenen Verfahren beim Aufsetzen des Bauelementes 180 zusätzlich noch ein räumlicher Versatz zwischen dem LED Chip 185 (erstes strukturelles Merkmal) und der geometrischen Mitte der in Figur 1 nicht dargestellten Bauelement-AnschlussStruktur 186 (zweites strukturelles Merkmal) berücksichtigt. Dieser Versatz kann beim Aufsetzen des Bauelementes 180 auf einfache Weise kompensiert werden durch eine adaptierte Position des Bestückungskopfes 110 innerhalb einer Verfahr-Ebene des Bestückungskopfes 110, wobei die Verfahr-Ebene parallel zu der Oberfläche der Leiterplatte 175 orientiert ist.

Die vorstehend anhand der Figuren 1a bis 1g beschriebenen Schritte zur Durchführung des in diesem Dokument beschriebenen Verfahrens zum optischen Vermessen der Struktur eines elektronischen Bauelementes 180 können anschaulich ausgedrückt wie folgt zusammengefasst werden:
Das Bauelement 180 wird vor dem eigentlichen Bestückungsvorgang aus einer Bauelement-Zuführeinheit abgeholt und auf einer durchsichtigen Platte der Messstation 150 bevorzugt genau im Mittelpunkt der beiden Kameras 120 und 160 abgelegt. Die beiden Kameras 120 und 160 vermessen dann jeweils die Mittelpunkte der für sie sichtbaren Merkmale. Dies sind der LED-Chip 185 und die Lötanschlüsse 186. Weichen die beiden Mittelpunkte in ihrer örtlichen Lage voneinander ab, so ist dies der für eine spätere Bestückung zu berücksichtigende Versatz zwischen dem LED-Chip 185 und den Lötanschlüssen 186. Da sich beim Wiederabholen des Bauelementes 180 ein weiterer Versatz des Bauelementes 180 zur entsprechenden Saugpipette 112 ergeben kann, wird das zu bestückende Bauelement 180 noch einmal mit der am Bestückungskopf 110 angebrachten Bauelementkamera 130 oder alternativ mit einer stationär eingebauten Bauelementkamera vermessen. Dann wird der Versatz zwischen dem Bauelement 180 und der Saugpipette 112 mit dem Versatz zwischen dem LED-Chip 185 und den Lötanschlüssen 186 verrechnet, so dass die Mitte des LED-Chips 185 exakt an einer vorgegebenen und gewünschten Position auf der Leiterplatte 175 zu liegen kommt.

Zur Ermittlung des Versatzes zwischen dem LED-Chip 185 (= erstes strukturelles Merkmal des LED Bauelementes 180) und der Lötanschlüsse 186 (= elektrische Bauelement-Anschlüsse oder zweites strukturelles Merkmal des LED Bauelementes 180) kann ein Paar von Kameras 120, 160 verwendet werden, deren optische Achsen zusammenfallen. In diesem Fall ist es nicht notwendig, einen Bezug des mit der einen Kamera gemessenen Mittelpunktes zum Bauelement 180 selbst (z.B. seine Außenkontur) zu erzeugen. Somit kann die Messung selbst bei Bauelementen mit sich ändernden Konturen, Oberflächen, Farben usw. immer stabil und konstant durchgeführt werden, solange die zu messenden Bereiche klar erkennbar sind. Selbst bei großen Bauteilen, deren Körper das Gesichtsfeld der betreffenden Kamera 120, 160 überragt, ist noch eine Messung möglich, solange das zu messende strukturelle Merkmal innerhalb des Gesichtsfeldes der betreffenden Kamera liegt. Die beschriebene Versatzmessung kann sehr genau erfolgen, da sie letzten Endes nur von der Auflösung der beiden Kameras 120, 160 abhängt. Eventuelle Fehler durch das Handhaben der Bauelemente (z.B. Aufnehmen, Ablegen) an der Messstation 150 können durch eine optische Vermessung des Bauelementes 180 mittels der optionalen Bauelementkamera 130 erfasst und durch eine geeignete Ansteuerung des Bestückungskopfes 110 (Position des Bestückungskopfes 110 und Winkellage der betreffenden Saugpipette 112) kompensiert werden.

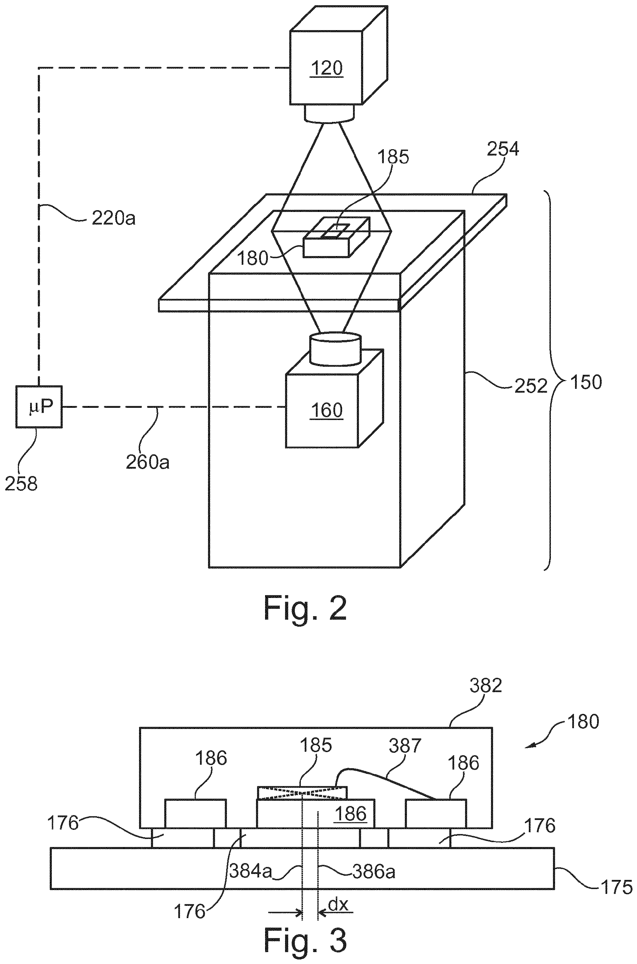

**Figur 2** zeigt die Messstation 150 in einer vergrößerten Darstellung. Die Messstation weist ein Gehäuse 252 auf, in welchem sich die zweite Kamera 160 befindet. An der Oberseite des Gehäuses 252 weist die Messstation 150 ein optisch transparentes Auflageelement 254 auf, welches zuvor als durchsichtige Platte bezeichnet wurde. Zur Vermessung des Versatzes zwischen (i) dem an der Oberseite des Bauelementes 180 befindlichen ersten strukturellen Merkmal 185 (hier der LED Chip 185) und (ii) dem an der Unterseite des Bauelementes 180 befindlichen zweiten strukturellen Merkmal (hier die Lötanschlüsse bzw. die elektrische Anschlussstruktur des Bauelementes 180) wird das Bauelement 180 auf das transparente Auflageelement 254 gelegt. Dort wird es dann gleichzeitig (i) von der zweiten Kamera 160 der Messstation 150 und (ii) von der Leiterplattenkamera 120 erfasst. Mittels einer Auswertevorrichtung 258, welche über Signalleitungen 260a und 220a mit der zweiten Kamera 160 bzw. der ersten Kamera 120 verbunden ist, werden die zwei von den beiden Kameras 160 und 120 aufgenommenen Bilder ausgewertet und daraus der räumliche Versatz zwischen dem ersten strukturellen Merkmal 185 (LED Chip) und dem zweiten strukturellen Merkmal (Bauelement-Anschlussstruktur ermittelt.

**Figur 3** zeigt in einer vergrößerten Darstellung das auf die Leiterplatte 175 aufgesetzte LED Bauelement 180. Das LED Bauelement 180 weist ein Bauelement-Gehäuse 382 auf, in welchem sich der LED Chip 185 befindet. Zum Kontaktieren des LED Chips 185 sind in dem Bauelement-Gehäuse 382 Bauelement-Anschlüsse 186 ausgebildet, über welche das LED Bauelement 180 mit Anschlusspads 176 auf der Leiterplatte 175 elektrisch leitend verbunden werden kann. Wie aus Figur 3 ersichtlich, ist eine Oberseite des LED Chips 185 über einen Bonddraht 387 mit dem rechten Bauelement-Anschluss der insgesamt drei Bauelement-Anschlüsse 186 verbunden. Die Unterseite des LED Chips 185 steht in direkten Kontakt mit dem mittleren Bauelement-Anschluss der drei Bauelement-Anschlüsse 186. Der linke Bauelement-Anschluss der drei Bauelement Anschlüsse 186 kann ebenfalls mit der Oberseite des LED Chips 185 verbunden werden. Alternativ kann der linke Bauelement-Anschluss 186 auch mit anderen Komponenten, beispielsweise mit einem weiteren nicht dargestellten LED Chip, des LED Bauelementes 180 verbunden werden.

Die geometrische Mitte des LED Chips 185 ist in Figur 3 durch eine gestrichelte Linie dargestellt, die mit dem Bezugszeichen 384a versehen ist. In entsprechender Weise ist die geometrische Mitte der Struktur der drei Bauelement-Anschlüsse 186 durch eine gestrichelte Linie dargestellt, die mit dem Bezugszeichen 386a versehen ist. Der räumliche Versatz zwischen dem LED Chip 185 (erstes strukturelles Merkmal) und der beispielsweise durch einen Leadframe des LED Bauelementes 180 festgelegten Bauelement-Anschlüsse (zweites strukturelles Merkmal) ist mit "dx" gekennzeichnet.

Wie vorstehend detailliert erläutert, wird bei dem in diesem Dokument beschriebenen Bestückungsverfahren dieser Versatz dx beim Aufsetzen des LED Bauelementes 180 berücksichtigt, so dass sich im Ergebnis der LED Chip 185 an einer in Bezug zu der Leiterplatte 175 optimalen "optischen" Position befindet.

Es wird darauf hingewiesen, dass es in der Praxis zwischen den beiden strukturellen Merkmalen nicht nur einen räumlichen Versatz dx entlang einer x-Richtung sondern selbstverständlich auch einen räumlichen Versatz "dy" entlang einer y-Richtung sowie eine (ungewollte) Verdrehung "dtheta" zwischen der Struktur des ersten strukturellen Merkmals und der Struktur des zweiten strukturellen Merkmals geben kann. Selbstverständlich können auch die Abweichungen "dy" und/oder "dtheta" beim Aufsetzen des LED Bauelementes 180 auf den Bauelementeträger 175 berücksichtigt werden.

### BEZUGSZEICHEN:

- 100: Bestückungssystem
- 110: Bestückungskopf / Revolverkopf
- 112: Bauelement Haltevorrichtungen / Saugpipetten
- 120: erste Kamera / Leiterplattenkamera
- 130: weitere Kamera / Bauelementkamera
- 150: Messstation
- 160: zweite Kamera
- 170: Zuführgurt
- 175: Bauelementeträger / Leiterplatte
- 176: Anschlusspads
- 180: elektronisches Bauelement / LED Bauelement
- 185: erstes strukturelles Merkmal / LED Chip
- 186: zweites strukturelles Merkmal / Bauelement-Anschlüsse

- 220a: Signalleitung
- 252: Gehäuse
- 254: optisch transparentes Auflageelement
- 258: Auswertevorrichtung
- 260a: Signalleitung

- 382: Bauelement-Gehäuse
- 384a: geometrische Mitte vom LED Chip
- 386a: geometrische Mitte von BE Anschlüssen
- 387: Bonddraht
- dx: Versatz

## Patentansprüche

1. Verfahren zum Montieren eines elektronischen Bauelementes (180) auf einen Bauelementeträger (175), das Verfahren aufweisend
optisches Erfassen eines ersten Bildes von einer ersten Seite des Bauelementes (180), an welcher ein erstes strukturelles Merkmal (185) des Bauelementes (180) erkennbar ist, mittels einer ersten Kamera (120),
optisches Erfassen eines zweiten Bildes von einer zweiten Seite des Bauelementes (180), an welcher ein zweites strukturelles Merkmal (186) des Bauelementes (180) erkennbar ist, mittels einer zweiten Kamera (160), wobei die erste Seite und die zweite Seite einander gegenüberliegend sind und wobei das zweite strukturelle Merkmal (186) konfiguriert ist, an einer vorbestimmten Position auf dem Bauelementeträger (175) angeschlossen zu werden,
Orientieren des elektronischen Bauelementes (180) so dass eine Mitte des ersten strukturellen Merkmals (185) mit einer gewünschten Position relativ zu dem Bauelementeträger (175) ausgerichtet ist, wobei das zweite strukturelle Merkmal (186) von der vorbestimmten Position entsprechend versetzt sein kann,
Messen eines räumlichen Versatzes (dx) zwischen dem zweiten strukturellen Merkmal (186) und dem ersten strukturellen Merkmal (185) basierend auf dem ersten Bild und dem zweiten Bild, um die korrekte räumliche Position von dem ersten strukturellen Merkmal (185) zu bestimmen, und
Montieren des elektronischen Bauelementes (180) auf den Bauelementeträger (175), wobei das elektronische Bauelement anhand des räumlichen zweiten strukturellen Merkmals (186) und unter Berücksichtigung des gemessenen räumlichen Versatzes (dx) räumlich positioniert wird, so dass die Mitte des ersten strukturellen Merkmals (185) relativ zu dem Bauelementeträger (175) so ausgerichtet ist, dass die Mitte des ersten strukturellen Merkmals an einer gewünschten und vorbestimmten Position auf dem Bauelementeträger (175) zu liegen kommt, wobei das zweite strukturelle Merkmal (186) von der vorbestimmten Position versetzt ist, und wobei
das elektronische Bauelement ein oberflächenmontiertes Bauelement (180) ist,
das elektronische Bauelement ein optoelektronisches Bauelement (180) ist, das erste strukturelle Merkmal ein Licht emittierender Chip (185) oder ein Licht empfangender Chip des optoelektronischen Bauelementes (180) ist, und
das zweite strukturelle Merkmal zumindest ein elektrischer Anschluss (186) des optoelektronischen Bauelementes (180) ist.

2. Verfahren gemäß dem vorangehenden Anspruch 1, wobei der räumliche Versatz (dx) in einer Ebene bestimmt wird, welche in Bezug zu der ersten Seite und/oder in Bezug zu der zweiten Seite parallel orientiert ist.

3. Verfahren gemäß einem der vorangehenden Ansprüche, wobei die erste Kamera (120) und zweite Kamera (160) einen festen räumlichen Bezug zueinander aufweisen.

4. Verfahren gemäß einem der vorangehenden Ansprüche, wobei eine erste optische Achse der ersten Kamera (120) und eine zweite optische Achse der zweiten Kamera (160) kollinear zueinander ausgerichtet sind.

5. Verfahren gemäß einem der vorangehenden Ansprüche, wobei die erste Kamera (120) und/oder die zweite Kamera (160) eine innerhalb eines Bestückungsautomaten (100) bewegliche Kamera ist.

6. Verfahren gemäß einem der vorangehenden Ansprüche 1 bis 4, wobei sich das Bauelement (180) während des Erfassens des ersten Bildes und während des Erfassens des zweiten Bildes in der gleichen Position befindet.

7. Verfahren gemäß dem vorangehenden Anspruch 6, wobei das erste Bild und das zweite Bild zu unterschiedlichen Zeitpunkten erfasst werden.

8. Verfahren gemäß dem vorangehenden Anspruch 6, wobei das erste Bild und das zweite Bild gleichzeitig erfasst werden.

9. Verfahren gemäß einem der vorangehenden Ansprüche 1 bis 5, wobei
sich das Bauelement (180) während des Erfassens des ersten Bildes in einer ersten Position befindet und wobei
sich das Bauelement (180) während des Erfassens des zweiten Bildes in einer zweiten Position befindet, wobei die erste Position unterschiedlich zu der zweiten Position ist.

10. Verfahren gemäß einem der vorangehenden Ansprüche 1 bis 9, wobei sich das elektronische Bauelement (180) auf einem optisch transparenten Auflageelement (254) befindet, wenn zumindest eines der beiden Bilder optisch erfasst wird.

11. Verfahren gemäß einem der vorangehenden Ansprüche 1 bis 9, wobei das elektronische Bauelement (180) von einer Klemmvorrichtung gehalten wird, wenn zumindest eines der beiden Bilder optisch erfasst wird.

12. Verfahren gemäß einem der vorangehenden Ansprüche, wobei
mittels der ersten Kamera (120) und/oder mittels der zweiten Kamera (160) mit jeweils einer Bildaufnahme eine Mehrzahl von Bildern von einer Mehrzahl von Bauelementen (180) aufgenommen und damit optisch erfasst wird, wobei jeweils ein Bild einem Bauelement (180) zugeordnet ist,
für jedes Bauelement (180) der Mehrzahl von Bauelementen (180) jeweils ein räumlicher Versatz (dx) zwischen zwei an unterschiedlichen Seiten des Bauelementes (180) befindlichen strukturellen Merkmalen (185, 186) basierend auf den entsprechenden aus unterschiedlichen Richtungen aufgenommenen Bildern des Bauelementes (180) bestimmt wird,
jedes der Mehrzahl von Bauelementen (180) orientiert wird, so dass jeweils eine Mitte des ersten strukturellen Merkmals (185) mit einer gewünschten Position relativ zu dem Bauelementeträger (175) ausgerichtet ist, wobei das jeweilige zweite strukturelle Merkmal (186) von der jeweiligen vorbestimmten Position entsprechend versetzt sein kann, und
Montieren der Mehrzahl von Bauelementen (180) auf den Bauelementeträger (175), wobei die Mitte von dem jeweiligen ersten strukturellen Merkmal (185) relativ zu dem Bauelementeträger (175) ausgerichtet ist, wobei das jeweilige zweite strukturelle Merkmal (186) von der jeweiligen vorgestimmten Position versetzt ist.

13. Verfahren gemäß einem der vorangehenden Ansprüche, wobei das erste Bild durch eine Saugpipette (112) hindurch erfasst wird.

14. Verfahren zum Überprüfen der Funktionsfähigkeit eines optoelektronischen Bauelementes (180), das Verfahren aufweisend
Bestimmen eines räumlichen Versatzes (dx) zwischen
(i) einem zweiten strukturellen Merkmal (186) des optoelektronischen Bauelementes (180), welches sich an einer zweiten Seite des Bauelementes (180) befindet, und
(ii) einem ersten strukturellen Merkmal (185) des optoelektronischen Bauelementes (180), welches sich an einer ersten Seite des Bauelementes (180) befindet, wobei die erste Seite und die zweite Seite einander gegenüberliegend sind,
mittels eines Teil-Verfahrens zum optischen Vermessen der Struktur von dem optoelektronischen Bauelement (180), wobei das Teil-Verfahren aufweist
optisches Erfassen eines ersten Bildes von der ersten Seite des optoelektronischen Bauelementes (180) mittels einer ersten Kamera (120),
optisches Erfassen eines zweiten Bildes von der zweiten Seite des Bauelementes (180) mittels einer zweiten Kamera (160) und
Bestimmen des räumlichen Versatzes (dx) basierend auf dem ersten Bild und dem zweiten Bild,
wobei das optoelektronische Bauelement (180) ein Licht emittierendes optoelektronisches Bauelement (180) ist und wobei das Verfahren ferner aufweist,
Kontaktieren des Licht emittierenden optoelektronischen Bauelementes (180) an einem optisch transparenten Trägerelement,
Einschalten des an dem optisch transparenten Trägerelement kontaktierten Licht emittierenden optoelektronischen Bauelementes (180),
Messen der Intensität von Licht, welches von dem eingeschalteten optoelektronischen Bauelement (180) emittiert wird, und
Überprüfen der Funktionsfähigkeit des optoelektronischen Bauelementes (180) basierend auf der gemessenen Intensität.

15. Verfahren gemäß dem vorangehenden Anspruch, ferner aufweisend
Vermessen einer räumlichen Verteilung der lokalen Leuchtdichte über eine Leuchtfläche (185) des optoelektronischen Bauelementes (180).

16. Bestückautomat zum Montieren eines elektronischen Bauelementes (180) auf einen Bauelementeträger (175), der Bestückautomat aufweisend einen Bestückkopf
(i) zum Aufnehmen des elektronischen Bauelementes (180),
(ii) zum Transportieren des aufgenommenen elektronischen Bauelementes (180) über den Bauelementeträger und
(iii) zum Aufsetzen des transportierten elektronischen Bauelementes (180) auf den Bauelementeträger (175),
eine erste Kamera (120),
eine zweite Kamera (160) und
eine mit den beiden Kameras (120, 160) gekoppelte Auswertevorrichtung (258), wobei die Auswertevorrichtung (258) eingerichtet ist, den Bestückautomaten zu veranlassen, das Verfahren gemäß einem der vorangehenden Ansprüche 1 bis 14 auszuführen.

## Claims

1. A method of mounting an electronic component (180) on a component carrier (175), the method comprising
optically capturing a first image of a first side of the component (180) at which a first structural feature (185) of the component (180) is recognizable, by means of a first camera (120),
optically capturing a second image of a second side of the component (180) at which a second structural feature (186) of the component (180) is recognizable, by means of a second camera (160),
wherein the first side and the second side are opposing each other and
wherein the second structural feature (186) is configured to be connected to a predetermined position on the component carrier (175),
orienting the electronic component (180), such that a center of the first structural feature (185) is aligned with a desired position relative to the component carrier (175),
wherein the second structural feature (186) may be respectively offset from the predetermined position,
measuring a spatial offset (dx) between the second structural feature (186) and the first structural feature (185) based on the first image and the second image, in order to determine the correct spatial position of the first structural feature (185), and
mounting the electronic component (180) on the component carrier (175),
wherein the electronic component is spatially positioned by means of the second structural feature (186) and under consideration of the measured spatial offset (dx), such that the center of the first structural feature (185) is aligned relative to the component carrier (175), such that the center of the first structural feature is situated at a desired and predetermined position on the component carrier (175),
wherein the second structural feature (186) is offset from the predetermined position, and wherein
the electronic component is a surface mounted component (180),
the electronic component is an optoelectronic component (180),
the first structural feature is a light emitting chip (185) or a light receiving chip of the optoelectronic component (180), and
the second structural feature is at least one electrical terminal (186) of the optoelectronic component (180).

2. The method according to the preceding claim 1, wherein
the spatial offset (dx) is determined in a plane which is oriented parallel with respect to the first side and/or with respect to the second side.

3. The method according to one of the preceding claims, wherein
the first camera (120) and the second camera (160) comprise a fixed spatial relation with respect to each other.

4. The method according to one of the preceding claims, wherein
a first optical axis of the first camera (120) and a second optical axis of the second camera (160) are aligned collinear with respect to each other.

5. The method according to one of the preceding claims, wherein
the first camera (120) and/or the second camera (160) is a camera which is movable within an assembly machine (100).

6. The method according to one of the preceding claims 1 to 4, wherein
the component (180) during capturing the first image and during capturing the second image is located in the same position.

7. The method according to the preceding claim 6, wherein
the first image and the second image are captured at different points in time.

8. The method according to the preceding claim 6, wherein the first image and the second image are captured at the same time.

9. The method according to one of the preceding claims 1 to 5, wherein
the component (180) is located in a first position during capturing the first image and wherein
the component (180) is located in a second position during capturing the second image, wherein the first position is different to the second position.

10. The method according to one of the preceding claims 1 to 9, wherein
the electronic component (180) is located on an optically transparent support element (254) when at least one of the both images is optically captured.

11. The method according to one of the preceding claims 1 to 9, wherein
the electronic component (180) is held by means of a clamping device when at least one of the both images is optically captured.

12. The method according to one of the preceding claims, wherein
by means of the first camera (120) and/or by means of the second camera (160) with respectively one image recording, a plurality of images of a plurality of components (180) is recorded and thereby optically captured, wherein respectively one image is assigned to one component (180),
for each component (180) of the plurality of components (180) respectively one spatial offset (dx) between two structural features (185, 186) which are located at different sides of the component (180) is determined based on the respective images of the component (180) which are recorded from different directions,
each of the plurality of components (180) is oriented, such that respectively a center of the first structural feature (185) is aligned with a desired position relative to the component carrier (175),
wherein the respective second structural feature (186) may be respectively offset from the respective predetermined position, and
mounting the plurality of components (180) on the component carrier (175), wherein the center of the respective first structural feature (185) is aligned relative to the component carrier (175),
wherein the respective second structural feature (186) is offset from the respective predetermined position.

13. The method according to one of the preceding claims, wherein
the first image is captured through a suction pipette (112).

14. A method of testing the functional capability of an optoelectronic component (180), the method comprising
determining a spatial offset (dx) between
(i) a second structural feature (186) of the optoelectronic component (180), which is located at a second side of the component (180), and
(ii) a second structural feature (185) of the optoelectronic component (180), which is located at a first side of the component (180), wherein the first side and the second side are opposing each other,
by means of a sub-method of optical measuring the structure of the optical component (180), wherein the sub-method comprises
optically capturing a first image of the first side of the optoelectronic component (180) by means of the first camera (120),
optically capturing a second image of the second side of the component (180) by means of a second camera (160) and
determining the spatial offset (dx) based on the first image and the second image,
wherein the optoelectronic component (180) is a light emitting optoelectronic component (180) and wherein the method further comprises
contacting the light emitting optoelectronic component (180) at an optically transparent carrier element,
switching on the light emitting optoelectronic component (180) which is contacted at the optically transparent carrier element,
measuring the intensity of light which is emitted by the switched on optoelectronic component (180), and
testing the functional capability of the optoelectronic component (180) based on the measured intensity.

15. The method according to the preceding claim, further comprising
measuring a spatial distribution of a local luminance over a luminous surface (185) of the optoelectronic component (180).

16. Assembly machine for mounting an electronic component (180) on a component carrier (175), the assembly machine comprising
an assembly head
(i) for accommodating the electronic component (180),
(ii) for transporting the accommodated electronic component (180) over the component carrier and
(iii) for placing the transported electronic component (180) onto the component carrier (175),
a first camera (120),
a second camera (160) and
an evaluating device (258) which is coupled to the both cameras (120,
160), wherein the evaluating device (258) is adapted to cause the assembly machine to execute the method according to one of the preceding claims 1 to 14.

## Revendications

1. Procédé pour monter un composant (180) électronique sur un support de composant (175), ledit procédé présentant les étapes suivantes consistant à :
détecter de manière optique une première image depuis un premier côté du composant (180), au niveau duquel une première caractéristique (185) structurelle du composant (180) peut être identifiée, au moyen d'une première caméra (120),
détecter de manière optique une deuxième image depuis un deuxième côté du composant (180), au niveau duquel une deuxième caractéristique (186) structurelle du composant (180) peut être identifiée, au moyen d'une deuxième caméra (160), où le premier côté et le deuxième côté se font face l'un l'autre et où la deuxième caractéristique (186) structurelle est configurée pour être raccordée au niveau d'une position prédéterminée sur le support de composant (175),
orienter le composant (180) électronique de sorte qu'un centre de la première caractéristique (185) structurelle soit orienté par rapport au support de composant (175) avec une position souhaitée, où la deuxième caractéristique (186) structurelle peut être décalée de manière correspondante de la position prédéterminée,
mesurer un décalage (dx) spatial entre la deuxième caractéristique (186) structurelle et la première caractéristique (185) structurelle sur la base de la première image et de la deuxième image afin de déterminer la position spatiale correcte de la première caractéristique (185) structurelle, et
monter le composant (180) électronique sur le support de composant (175), où le composant électronique est positionné spatialement à l'aide de la deuxième caractéristique (186) structurelle et en tenant compte du décalage (dx) spatial mesuré de sorte que le centre de la première caractéristique (185) structurelle soit orienté par rapport au support de composant (175) de sorte que le centre de la première caractéristique structurelle vienne au niveau d'une position souhaitée et prédéterminée sur le support de composant (175), où la deuxième caractéristique (186) structurelle est décalée de la position prédéterminée, et où
le composant électronique est un composant (180) monté en surface,
le composant électronique est un composant (180) optoélectronique,
la première caractéristique structurelle est une puce (185) émettant de la lumière ou une puce recevant de la lumière du composant (180) optoélectronique, et
la deuxième caractéristique structurelle est au moins un raccord (186) électrique du composant (180) optoélectronique.

2. Procédé selon la revendication 1 précédente, **caractérisé en ce**
**que** le décalage (dx) spatial est déterminé dans un plan, qui est orienté de manière parallèle par rapport au premier côté et/ou par rapport au deuxième côté.

3. Procédé selon l'une quelconque des revendications précédentes, **caractérisé en ce**
**que** la première caméra (120) et la deuxième caméra (160) présentent un rapport l'une par rapport à l'autre spatial fixe.

4. Procédé selon l'une quelconque des revendications précédentes, **caractérisé en ce**
**qu'**un premier axe optique de la première caméra (120) et un deuxième axe optique de la deuxième caméra (160) sont orientés de manière colinéaire l'un par rapport à l'autre.

5. Procédé selon l'une quelconque des revendications précédentes, **caractérisé en ce**
**que** la première caméra (120) et/ou la deuxième caméra (160) est une caméra mobile à l'intérieur d'une machine automatique de mise en place (100).

6. Procédé selon l'une quelconque des revendications 1 à 4, **caractérisé en ce**
**que** le composant (180) se trouve au cours de la détection de la première image et au cours de la détection de la deuxième image dans la même position.

7. Procédé selon la revendication 6 précédente, **caractérisé en ce**
**que** la première image et la deuxième image sont détectées à des moments différents.

8. Procédé selon la revendication 6 précédente, **caractérisé en ce**
**que** la première image et la deuxième image sont détectées de manière simultanée.

9. Procédé selon l'une quelconque des revendications 1 à 5, **caractérisé en ce**
**que** le composant (180) se trouve au cours de la détection de la première image dans une première position et en ce
**que** le composant (180) se trouve au cours de la détection de la deuxième image dans une deuxième position, où la première position est différente par rapport à la deuxième position.

10. Procédé selon l'une quelconque des revendications précédentes 1 à 9, **caractérisé en ce**
**que** le composant (180) électronique se trouve sur un élément de réception (254) transparent optiquement, quand au moins une des deux images est détectée optiquement.

11. Procédé selon l'une quelconque des revendications précédentes 1 à 9, **caractérisé en ce**
**que** le composant (180) électronique est maintenu par un dispositif de serrage, quand au moins une des deux images est détectée optiquement.

12. Procédé selon l'une quelconque des revendications précédentes, **caractérisé en ce**
**qu'**une pluralité d'images sont prises d'une pluralité de composants (180) et ainsi détectées optiquement au moyen de la première caméra (120) et/ou au moyen de la deuxième caméra (160) avec respectivement une prise d'image, où respectivement une image est associée à un composant (180),
**que** pour chaque composant (180) de la pluralité de composants (180), respectivement un décalage (dx) spatial entre deux caractéristiques (185, 186) structurelles se trouvant au niveau de côtés différents du composant (180) est déterminé sur la base des images prises, correspondantes depuis différentes directions, du composant (180),
**que** chaque composant de la pluralité de composants (180) est orienté de sorte que respectivement un centre de la première caractéristique (185) structurelle soit orienté par rapport au support de composant (175) avec une position souhaitée, où la deuxième caractéristique (186) structurelle respective peut être décalée de manière correspondante de la position prédéterminée respective, et
**que** la pluralité de composants (180) sont montés sur le support de composant (175), où le centre de la première caractéristique (185) structurelle respective est orienté par rapport au support de composant (175), où la deuxième caractéristique (186) structurelle respective est décalée de la position prédéterminée respective.

13. Procédé selon l'une quelconque des revendications précédentes, **caractérisé en ce**
**que** la première image est détectée à travers une pipette d'aspiration (112).

14. Procédé pour vérifier l'aptitude au fonctionnement d'un composant (180) optoélectronique, lequel procédé présentant les étapes suivantes consistant à :
déterminer un décalage (dx) spatial entre
(i) une deuxième caractéristique (186) structurelle du composant (180) optoélectronique, qui se trouve au niveau d'un deuxième côté du composant (180), et
(ii) une première caractéristique (185) structurelle du composant (180) optoélectronique, qui se trouve au niveau d'un premier côté du composant (180), où le premier côté et le deuxième côté se font face l'un l'autre,
au moyen d'un procédé partiel pour mesurer de manière optique la structure du composant (180) optoélectronique, où le procédé partiel présente les étapes suivantes consistant à :
détecter de manière optique une première image du premier côté du composant (180) optoélectronique au moyen d'une première caméra (120),
détecter de manière optique une deuxième image du deuxième côté du composant (180) au moyen d'une deuxième caméra (160) et
déterminer le décalage (dx) spatial sur la base de la première image et de la deuxième image,
où le composant (180) optoélectronique est un composant (180) optoélectronique émettant de la lumière et où le procédé présente en outre les étapes suivantes consistant à :
mettre en contact le composant (180) optoélectronique émettant de la lumière au niveau d'un élément de support transparent optiquement,
activer le composant (180) optoélectronique émettant de la lumière mis en contact au niveau de l'élément de support optiquement transparent,
mesurer l'intensité de la lumière, qui est émise par le composant (180) optoélectronique activé, et
surveiller l'aptitude au fonctionnement du composant (180) optoélectronique sur la base de l'intensité mesurée.

15. Procédé selon la revendication précédente, présentant en outre l'étape consistant à :
mesurer une répartition spatiale de la luminance locale sur une surface lumineuse (185) du composant (180) optoélectronique.

16. Machine automatique de mise en place pour monter un composant (180) électronique sur un support de composant (175), ladite machine automatique de mise en place présentant
une tête de mise en place
(i) pour recevoir le composant (180) électronique,
(ii) pour transporter le composant (180) électronique reçu au-dessus du support de composant, et
(iii) pour placer le composant (180) électronique transporté sur le support de composant (175),
une première caméra (120),
une deuxième caméra (160), et
un dispositif d'analyse (258) couplé aux deux caméras (120, 160), où le dispositif d'analyse (258) est mis au point pour amener la machine automatique de mise en place à exécuter le procédé selon l'une quelconque des revendications 1 à 14.
